Europäisches Patentamt

European Patent Office

Office européen des brevets

(11) Veröffentlichungsnummer: **0 106 185**
**A2**

## (12) EUROPÄISCHE PATENTANMELDUNG

(21) Anmeldenummer: **83109252.3**

(22) Anmeldetag: **19.09.83**

(51) Int. Cl.³: **G 06 K 19/04**
**B 23 Q 41/02, G 11 C 23/00**

(30) Priorität: **13.10.82 DE 3237880**

(43) Veröffentlichungstag der Anmeldung: ⌐
**25.04.84 Patentblatt 84/17**

(84) Benannte Vertragsstaaten:
**DE FR GB IT**

(71) Anmelder: **ROBERT BOSCH GMBH**
**Postfach 50**
**D-7000 Stuttgart 1(DE)**

(72) Erfinder: **Geissler, Lorenz, Dipl.-Ing.**
**Sennereiweg 5**
**D-8975 Fischen 1(DE)**

(54) **Kodierspeicher, insbesondere für Werkstückträger in der Fliessfertigung.**

(57) Kodierspeicher, insbesondere für Werkstückträger in der Fließfertig, mit mindestens einem Kodierelement (40) und einem Betätigungsglied (42) für das Kodierelement (40), die beide über einen einstückigen, gebogenen Schieber (20) miteinander gekoppelt sind, welcher in einem gekrümmten Kanal (22) verschiebbar geführt ist. Bei einer bevorzugten Ausführung sind das Kodierelement (40) und das Betätigungsglied (42) durch die beiden aus dem Kanal (22) heraustretenden Endabschnitte des Schiebers (20) selbst gebildet. Dadurch ergibt sich eine einfache, kompakte Ausführung des Kodierspeichers, bei welcher mehrere Kodierelemente unmittelbar nebeneinanderliegend vorgesehen und in den Werkstückträger integriert werden können.

FIG.1

EP 0 106 185 A2

Croydon Printing Company Ltd.

0106185

R. 18098

20.8.1982 Ki/Le

ROBERT BOSCH GMBH, 7000 STUTTGART 1

Kodierspeicher, insbesondere für
Werkstückträger in der Fließfertigung

Stand der Technik

Die Erfindung geht aus von einem Kodierspeicher nach
der Gattung des Hauptanspruchs. Kodierspeicher dieser
Gattung dienen beispielsweise zum Kodieren und Speichern
von Informationen, welche den Bearbeitungszustand eines
an einem Werkstückträger aufliegenden Werkstückes und
dessen weitere Behandlung betreffen. Bei einem bekannten Kodierspeicher der eingangs genannten Gattung
(DE-OS 30 12 358.1) ist das Übertragungsgestänge durch
eine Reihe von aneinanderliegenden Kugeln gebildet.
Diese Ausführung bedingt einen gewissen Aufwand bei
der Fertigung und benötigt auch einen verhältnismäßig
großen Krümmungsradius des die Kugeln aufnehmenden
Kanals. Die einzelnen Bauelemente des bekannten Kodierspeichers sind daher in einem blockförmigen Gehäuse
untergebracht, welches für sich vormontiert und danach
an dem Werkstückträger angebaut wird.

...

- 2 -

Vorteile der Erfindung

Die erfindungsgemäße Anordnung mit den kennzeichnenden
Merkmalen des Hauptanspruchs hat demgegenüber den Vorteil, daß die einzelnen Bauelemente des Kodierspeichers
einfacher montierbar sind und daß der Krümmungsradius
des Kanals für den einstückigen Schieber kleiner gewählt werden kann als der Krümmungsradius für den die
Kugeln der bekannten Anordnung aufnehmenden Kanal. Die
erfindungsgemäße Anordnung benötigt daher auch weniger
Platz in Verschieberichtung des Kodierelements, so daß
sie sich auch für den unmittelbaren Einbau in den Werkstückträger eignet.

Durch die in den Unteransprüchen aufgeführten Maßnahmen
sind vorteilhafte Weiterbildungen der im Hauptanspruch
angegebenen Anordnung möglich.

Die einstückige Ausführung des Übertragungsgestänges eröffnet die Möglichkeit, dieses mit dem Kodierelement und/
oder mit dem Bedienungsglied für das Kodierelement einstückig zu verbinden, wodurch die Anordnung weiter vereinfacht wird. Zweckmäßig ist dabei, daß der das Übertragungsgestänge aufnehmende Kanal erst nach dem Einlegen
des Schiebers vollständig gebildet wird. Das kann mit
fertigungsgerechten Mitteln dadurch geschehen, daß der
Kanal durch eine Mulde in der Tragfläche des Werkstückträgers und eine die Mulde bis auf die beiden Kanalmündungen nach oben abdeckenden Einsatzkörper begrenzt
ist.

Eine besonders einfache und gedrängte Ausführung ergibt
sich, wenn das Kodierelement und das Betätigungsglied

...

- 3 -

durch die beiden aus dem Kanal heraustretenden Endabschnitte des Schiebers selbst gebildet sind. In diesem
Falle können auch mehrere, je ein Kodierelement bildende
Schieber unmittelbar aneinanderstoßend und sich gegenseitig seitlich führend in einem gemeinsamen Kanal gelagert sein.

Zur einwandfreien seitlichen Führung empfiehlt es sich,
daß der Kanal und die Schieber einen rechteckigen Querschnitt haben.

In manchen Fällen kann es vorteilhaft sein, wenn auch
das Betätigungsglied bzw. der entsprechende Endabschnitt
des Schiebers als Kodierelement abfragbar ausgebildet ist.

Zeichnung

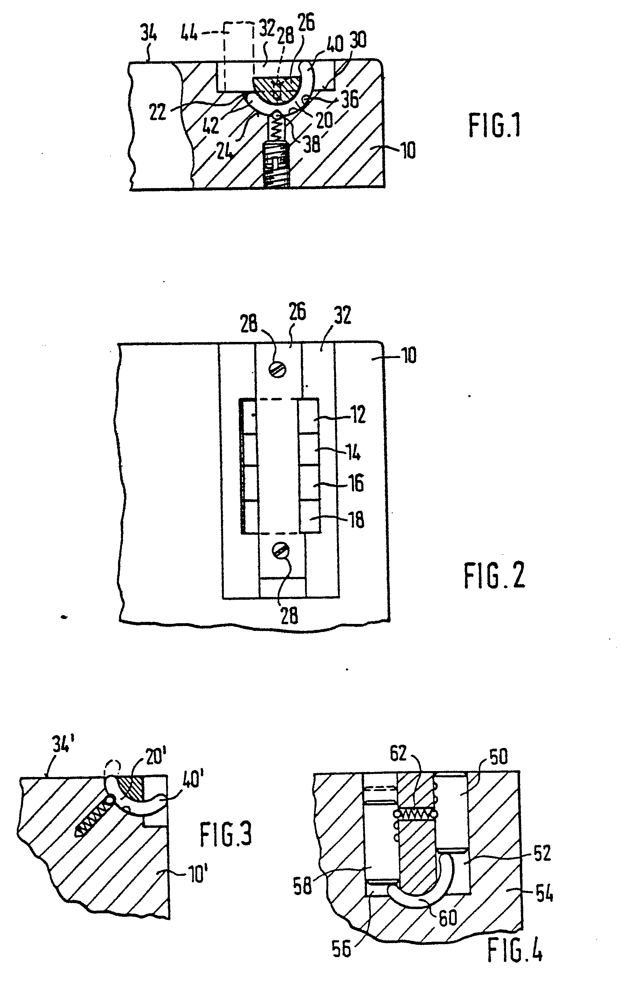

Drei Ausführungsbeispiele der Erfindung sind in der
Zeichnung dargestellt und in der nachfolgenden Beschreibung erläutert. Es zeigen Figur 1 das erste Ausführungsbeispiel im Schnitt, Figur 2 eine Draufsicht
auf den Kodierspeicher nach Figur 1, Figur 3 das zweite
und Figur 4 das dritte Ausführungsbeispiel, jeweils im
Schnitt.

Beschreibung der Ausführungsbeispiele

Der Kodierspeicher nach den Figuren 1 und 2 ist in einen
palettenförmigen Werkstückträger 10 integriert und hat
vier nebeneinanderliegende Kodiereinheiten 12, 14, 16, 18
(Figur 2). Eine jede dieser Kodiereinheiten 12 bis 18 ist
durch einen halbschalenförmigen Schieber 20 (Figur 1) gebildet, der einen rechteckförmigen Querschnitt hat und in
einem für alle Kodiereinheiten gemeinsamen Kanal 22 verschiebbar geführt ist. Der Kanal 22 ist gebildet durch

. . .

- 4 -

eine im Querschnitt kreissegmentförmige Mulde 24 im Werkstückträger 10, welche nach dem Einlegen der Schieber 20 durch einen im Querschnitt halbkreisförmigen Einsatzkörper 26 bis auf die beiden Mündungen des Kanals 22 nach oben abgedeckt ist. Dieser ist durch außerhalb der Mulde 24 angeordnete Schrauben 28 am Werkstückträger 10 befestigt. Die Mündungen des Kanals 22 liegen in einer Fläche 30 des Werkstückträgers 10, welche durch den Boden einer Vertiefung 32 in dessen Tragfläche 34 gebildet ist.

Die Krümmungsradien der Mulde 24 und des Einsatzkörpers 26 sind dem Biegeradius der Schieber 20 so angepaßt, daß sich die Schieber 20 im Kanal 22 spielfrei verschieben lassen. Jeder Schieber 20 hat drei im Winkel zueinander versetzte Rastlöcher 36, in welche eine am Werkstückträger 10 federnd verschiebbar gelagerte Rastkugel 38 einzugreifen vermag. Die Teile sind so aufeinander abgestimmt, daß in der einen Endstellung des Schiebers 20 dessen einer Endabschnitt 40 und in der anderen Endstellung dessen anderer Endabschnitt 42 aus dem Kanal 22 herausragt und von außen zugänglich ist.

Die Endabschnitte 40 der Schieber 20 bilden die eigentlichen Kodierelemente der Kodiereinheiten 12 bis 18, deren Stellung einer bestimmten Information entspricht, welche durch an der Transportbahn des Werkstückträgers 10 angeordnete Lesegeräte abfragbar ist. Die anderen Endabschnitte 42 der Schieber 20 dienen als Betätigungsglieder für die Endabschnitte 40, wenn diese entgegen dem Uhrzeigersinn aus dem Kanal 22 heraus in die in Figur 1 gezeigte Stellung geschoben werden sollen. Dieses Verschieben kann unter Zuhilfenahme eines in Figur 1 angedeuteten Kodierstiftes 44 erfolgen. Zum Verschieben des

...

Kodierelementes 40 in der anderen Richtung ist dieses
von außen unmittelbar zugänglich. Die Vertiefung 32 ist
so bemessen, daß die Endabschnitte 40, 42 des Schiebers
20 nicht über die Tragfläche 34 des Werkstückträgers 10
hervorstehen.

Der Kodierspeicher nach Figur 3 ist unmittelbar neben
einer Längsseite des Werkstückträgers 10' angeordnet,
so daß der eine Endabschnitt 40' des Schiebers 20' von
der Seite des Werkstückträgers 10' her abfragbar und
zurückschiebbar ist. Die Bewegung des Schiebers 20' in
der anderen Richtung kann wieder von der Seite der Tragfläche 34' des Werkstückträgers 10' her erfolgen.

Der Kodierspeicher nach Figur 4 hat einen Kodierbolzen
50, welcher in einer Bohrung 52 eines Werkstückträgers
54 verschiebbar gelagert ist. Parallel zur Bohrung 52
ist die Bohrung 56 vorgesehen, die ein bolzenförmiges
Betätigungsglied 58 verschiebbar aufnimmt. Der Kodierbolzen 50 und das Betätigungsglied 58 sind über ein
Gestänge 60 miteinander gekoppelt, welches erfindungsgemäß durch einen einstückigen, gebogenen Schieber gebildet ist. Zur Lagerung der Führung des Gestänges bzw.
Schiebers 60 können die gleichen Mittel und Maßnahmen
wie bei den vorbeschriebenen Ausführungsbeispielen vorgesehen werden. Der Kodierbolzen 50 ist durch eine Rasteinrichtung 62 in drei verschiedenen Stellungen festhaltbar, so daß er drei verschiedene Informationen
speichern kann. Die Rasteinrichtung 62 dient gleichzeitig auch zum Verrasten des Betätigungsgliedes 58,
welches im Bedarfsfall ebenfalls als abfragbares Kodierelement dienen kann.

R. 18099
20.9.1982 Ki/Le

ROBERT BOSCH GMBH, 7000 STUTTGART 1

Ansprüche

1. Kodierspeicher, insbesondere für Werkstückträger in
der Fließfertigung, mit mindestens einem mechanischen
Kodierelement, welches in einer von feststehenden Wänden
begrenzten und an einer Seite von außen zugänglichen
Kammer verschiebbar geführt und mindestens in zwei verschiedenen Schiebestellungen durch Rastmittel festhaltbar ist, wobei jede Schiebestellung einer gespeicherten
Information entspricht, welche durch ein sich relativ
zum Kodierelement bewegendes Lesegerät abfragbar ist,
und ferner mit Mitteln zum Verschieben des Kodierelements
gegen das von außen zugängliche Ende der Kammer, bestehend aus einem neben dem Kodierelement verschiebbar
gelagerten Betätigungsglied und einem Übertragungsgestänge, welches sich durch einen gekrümmten Kanal hindurch erstreckt, der in die in das Kodierelement aufnehmende Kammer führt, dadurch gekennzeichnet, daß der
das Übertragungsgestänge aufnehmende Kanal (22) über
seine gesamte Länge kreisbogenförmig gekrümmt ist und
daß das Übertragungsgestänge durch einen einstückigen
gebogenen Schieber (20) gebildet ist, dessen Biegeradius
dem Krümmungsradius des Kanals (22) entspricht.

...

2. Kodierspeicher nach Anspruch 1, dadurch gekennzeichnet, daß das Kodierelement (40) einstückig mit
dem das Übertragungsgestänge bildenden Schieber (20)
verbunden ist.

3. Kodierspeicher nach Anspruch 1 oder 2, dadurch gekennzeichnet, daß das Bestätigungsglied (42) einstückig
mit dem das Übertragungsgestänge bildenden Schieber
(20) verbunden ist.

4. Kodierspeicher nach den Ansprüchen 2 und 3, dadurch gekennzeichnet, daß das Kodierelement (20) und
das Betätigungsglied (42) durch die beiden aus dem
Kanal (22) heraustretenden Endabschnitte des Schiebers
(20) selbst gebildet sind.

5. Kodierspeicher nach Anspruch 4, dadurch gekennzeichnet, daß mehrere, je ein Kodierelement (40) bildende
Schieber (20) sich gegenseitig berührend und seitlich
führend in einem gemeinsamen Kanal (22) gelagert sind.

6. Kodierspeicher nach Anspruch 5, dadurch gekennzeichnet, daß der Kanal (22) und die Schieber (20)
einen rechteckigen Querschnitt haben.

7. Kodierspeicher nach einem der vorhergehenden Ansprüche, dadurch gekennzeichnet, daß der Kanal (22)
durch eine Mulde (24) in der Tragfläche (34) des Werkstückträgers (10) und eine die Mulde (24) bis auf die
beiden Kanalmündungen nach oben abdeckenden Einsatzkörpers (26) gebildet ist.

8. Kodierspeicher nach einem der vorhergehenden Ansprüche, dadurch gekennzeichnet, daß auch das Betätigungsglied (42) bzw. der entsprechende Endabschnitt des
Schiebers (20) als Kodierelement abfragbar ist.

FIG.1

FIG.2

FIG.3

FIG.4